# EUROPEAN PATENT APPLICATION

(11) **EP 4 847 686 A1**
(43) Date of publication of application: **02.12.2026**
(21) Application number: 24920280.5
(22) Date of filing: 23.10.2024
(51) Int. Cl.: D06M 13/513, C03C 25/40, D03D 1/00, D03D 15/267, H05K 1/03

(54) **GLASS CLOTH, PREPREG, AND PRINTED WIRING BOARD**

(30) Priority: 23.01.2024 JP 2024008261
(71) Applicant: ASAHI KASEI KABUSHIKI KAISHA, Tokyo 100-0006 (JP)
(72) Inventor: HIROSE, Amane, Tokyo 100-0006 (JP); HASHIMOTO, Yuka, Tokyo 100-0006 (JP); FUNAMI, Shingo, Tokyo 100-0006 (JP)
(74) Representative: Hoffmann Eitle
(86) International application number: PCT/JP2024/037665
(87) International publication number: WO 2025/158733

(57) **Abstract**

The purpose of the present disclosure is to provide a glass cloth capable of achieving excellent dielectric characteristics, suppressing an increase in dielectric loss tangent over time, and achieving excellent solder heat resistance for a resin substrate manufactured using said glass cloth. A glass cloth according to the present disclosure is obtained by weaving a glass yarn. The glass cloth is surface-treated with a surface treatment agent. The difference (dielectric loss tangent - bulk dielectric loss tangent) between the dielectric loss tangent of the glass cloth at 10 GHz and the bulk dielectric loss tangent of glass forming the glass yarn at 10 GHz is less than 0.00000. White spots P are present in the glass cloth at 10 spots/m² or less.

## Description

### FIELD

The present disclosure relates to a glass cloth, a prepreg and a printed circuit board.

### BACKGROUND

Current trends continue to progress toward increasingly higher performance of data terminals such as smartphones and higher-speed communication, including 5G communication. At the same time, advances are being made in the field of printed circuit boards for high-speed communication, in terms of lower relative permittivity and lower dielectric loss tangents for the insulating materials used to reduce transmission loss, and demand is increasing for even higher insulating reliability.

Examples of insulating materials for use in printed circuit boards for high-speed communication are reported in PTLs 1 and 2. Specifically, in both PTLs 1 and 2, a glass cloth is impregnated with a low-dielectric thermosetting resin that becomes crosslinked by radical reaction with a polyphenylene ether that has been modified at the ends with vinyl or methacryloxy groups, thus becoming hardened by the crosslinking (hereinafter referred to collectively as "matrix resin"), and it is then dried to obtain a prepreg. Laminated sheets are known that are obtained by laminating prepregs obtained in this manner, and curing them by heating and pressing. The goal in PTLs 1 and 2 is to realize low permittivity and a low dielectric loss tangent for a laminated sheet, by combination with a glass cloth having low permittivity and a low dielectric loss tangent.

For the goal of lowering the dielectric loss tangent of a glass cloth, PTLs 3 and 4 report that the amount of silanol groups on a silica glass cloth surface is reduced by heating the glass at high temperature. PTL 5 also reports that the number of silanol groups on a glass cloth surface is reduced by surface treatment, and that this lowers the dielectric loss tangent of the glass cloth. PTL 6 describes a packaging method for a quartz glass cloth, devised to inhibit progressive increase in the dielectric loss tangent of a quartz glass cloth with time.

### [CITATION LIST]

### [PATENT LITERATURE]

[PTL 1] International Patent Publication No. WO2019/065940
[PTL 2] International Patent Publication No. WO2019/065941
[PTL 3] Japanese Unexamined Patent Publication No. 2021-63320
[PTL 4] Japanese Unexamined Patent Publication No. 2021-195689
[PTL 5] Japanese Unexamined Patent Publication No. 2020-194888
[PTL 6] Japanese Patent Publication No. 7375902

### SUMMARY

### [TECHNICAL PROBLEM]

Even given the prior art technology described in PTLs 1 to 6, however, it has still been strongly desired to devise techniques that can further lower the dielectric loss tangents of glass cloths.

Glass cloths have been expected to exhibit not only excellent dielectric characteristics, but also various other properties (such as soldering heat resistance) for fabricated resin substrates.

It has also been strongly desired to develop techniques for inhibiting increase in the dielectric loss tangent with time without employing the methods for packaging quartz glass cloths used in prior art such as PTL 6.

It is an object of the present disclosure to provide a glass cloth that can exhibit excellent dielectric characteristics, can inhibit increase in the dielectric loss tangent with time, and that can exhibit excellent soldering heat resistance for resin substrates fabricated using glass cloths.

It is another object of the disclosure to provide a prepreg and printed circuit board produced using the glass cloth described above, as well as a method for producing the glass cloth.

### [SOLUTION TO PROBLEM]

One aspect of the present invention is as follows.
[1] A glass cloth formed by weaving glass yarn, wherein:
   the glass cloth is surface-treated with a surface treatment agent, and
   the difference between the dielectric loss tangent of the glass cloth at 10 GHz and the bulk dielectric loss tangent of the glass composing the glass yarn at 10 GHz (dielectric loss tangent - bulk dielectric loss tangent) is less than 0.00000, and
   the number of white spots of the glass cloth is 10/m² or less.
[2] A glass cloth according to [1], wherein the silicon (Si) content of the glass yarn is 95.0 to 100 mass% in terms of silicon dioxide (SiO₂).
[3] A glass cloth according to [1] or [2], wherein the average degree of opening of the warp yarn and weft yarn of the glass cloth is greater than 40%, as calculated from their respective yarn widths.
[4] A glass cloth according to any one of [1] to [3], wherein the bulk dielectric loss tangent is 0.002 or lower.
[5] A glass cloth according to any one of [1] to [4], wherein the surface treatment agent comprises a silane coupling agent.
[6] A glass cloth according to [5], wherein the molecular weight of the silane coupling agent is 250 to 1000.
[7] A glass cloth according to [5] or [6], wherein the silane coupling agent comprises in the molecule at least one group selected from the group consisting of epoxy, amino, aromatic vinyl, acryloyl and methacryloyl groups.
[8] A glass cloth according to any one of [5] to [7], wherein the surface treatment agent comprises two or more silane coupling agents with different molecular weights.
[9] A glass cloth according to any one of [1] to [8], wherein the ignition loss value of the glass cloth is 0.01 to 0.5 mass%.
[10] A glass cloth according to any one of [1] to [9], which is a constituent material for a printed circuit board.
[11] A prepreg that comprises a glass cloth according to any one of [1] to [10], and a thermosetting resin.
[12] A printed circuit board that comprises a prepreg according to [11].
[13] An integrated circuit that comprises a printed circuit board according to [12].
[14] An electronic device that comprises a printed circuit board according to [12].
[15] A method for producing a glass cloth, comprising:
   a weaving step in which glass yarn is woven to obtain a glass cloth, and
   a surface treatment step in which the glass yarn is subjected to deoiling treatment, and the glass yarn is then surface-treated with a surface treatment solution,
   wherein the dielectric loss tangent of the glass cloth at 10 GHz after surface treatment is lower than the dielectric loss tangent of the glass cloth at 10 GHz before surface treatment.
[16] The method for producing a glass cloth according to [15], wherein the surface treatment solution is prepared by adding an acidic aqueous solution to a silane coupling agent as a surface treatment agent.
[17] The method for producing a glass cloth according to [15] or [16], wherein the surface treatment step comprises:
   a step of controlling the temperature and pH of the surface treatment solution, and
   a step of filtering the surface treatment solution.
[18] The method for producing a glass cloth according to any one of [15] to [17], which further comprises a step of opening the glass yarn after the surface treatment step.
[19] The method for producing a glass cloth according to any one of [15] to [18], which further comprises a step of examining white spots in the glass cloth after the surface treatment step.

### [ADVANTAGEOUS EFFECTS OF INVENTION]

The present disclosure provides a glass cloth that can exhibit excellent dielectric characteristics, can inhibit increase in the dielectric loss tangent with time, and that can exhibit excellent soldering heat resistance for resin substrates fabricated using glass cloths.

The disclosure further provides a prepreg, a printed circuit board, an integrated circuit and an electronic device produced using the glass cloth, as well as a method for producing the glass cloth.

### BRIEF DESCRIPTION OF DRAWINGS

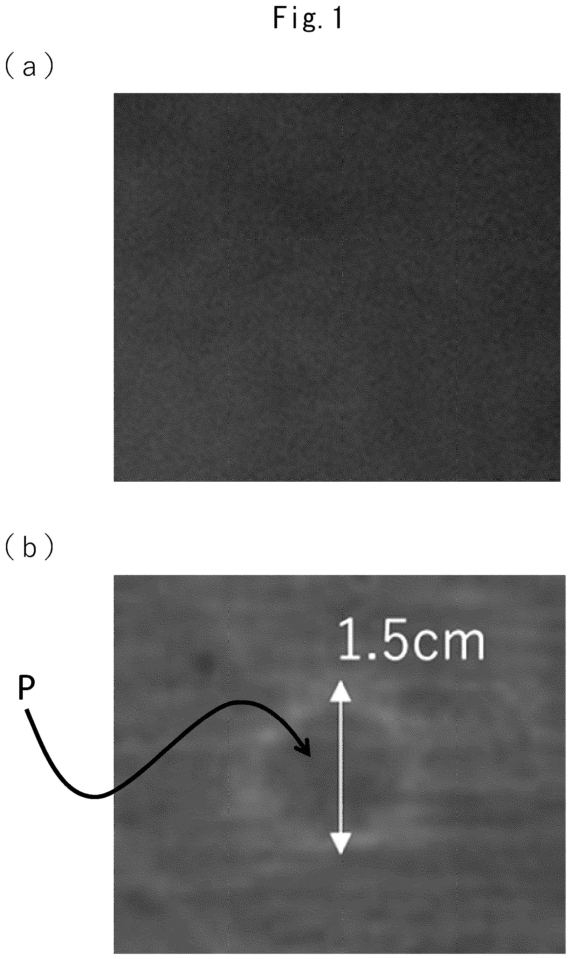

Fig. 1 is a diagram showing a white spot for illustration in the Examples.

### DESCRIPTION OF EMBODIMENTS

An embodiment of the present disclosure (hereunder referred to as "the embodiment") will now be described. However, the invention is not limited merely to the embodiment and may incorporate various modifications without falling outside of the scope of its gist.

Throughout the present specification, in cases where multiple structures represented by the same reference numerals exist in the same formula, such structures may be independently selected and may be the same or different, unless separately specified. Even in cases where multiple structures in different formulas are represented by the same reference numerals, such structures may be independently selected and may be the same or different, unless separately specified. The measurements referred to herein were carried out based on the Examples, unless otherwise specified. The upper limits and lower limits for the stepwise numerical ranges specified herein may be replaced with upper limits or lower limits in other corresponding stepwise numerical ranges, or they may be replaced by corresponding values mentioned in the Examples.

The term "step", as used herein, refers not only to an independent step, but also includes any function added to the step, even if it cannot be clearly distinguished from another step. The scales, forms and lengths shown in the drawings are exaggerated for clarity.

### [Glass cloth]

The glass cloth of the embodiment is a glass cloth obtained by weaving glass yarn, and for example, it is a glass cloth obtained by weaving glass yarn composed of a plurality of glass filaments as warp yarn and weft yarn.

According to one aspect of the embodiment,
the glass cloth is surface-treated with a surface treatment agent,
the difference between the dielectric loss tangent of the glass cloth at 10 GHz and the bulk dielectric loss tangent of the glass composing the glass yarn at 10 GHz (dielectric loss tangent - bulk dielectric loss tangent) is less than 0.00000, and
the number of white spots is 10/m² or less (for example, 10.0/m² or less).

This embodiment provides a glass cloth that can exhibit excellent dielectric characteristics, can inhibit increase in the dielectric loss tangent with time, and that can exhibit excellent soldering heat resistance for resin substrates (printed circuit boards) fabricated using glass cloths. The glass cloth of the embodiment is suitable as a constituent material for fabrication of prepregs, printed circuit boards, integrated circuits and electronic devices.

As a result of much diligent research, the present inventors decided to focus on use of a surface-treated glass cloth after heat deoiling at high temperature. The present inventors have been the first to find that, since a glass cloth having a lower value for the bulk dielectric loss tangent has an excessively low number of silanol groups on the glass surface, it is less likely to adsorb moisture present in the storage environment, and that this can therefore inhibit progressive increase in the dielectric loss tangent of the glass cloth with time, without implementing any special packaging.

It was further found that in order to obtain a glass cloth having a lower dielectric loss tangent value than the dielectric loss tangent of the glass bulk, surface treatment with a surface treatment agent of relatively high hydrophobicity is preferred. However, because such surface treatment agents have very poor dispersibility in and/or compatibility with water, they tend to produce defects in outer appearance, known as "white spots", on glass cloth surfaces, which are caused by the surface treatment agents. Because such white spots inhibit adhesiveness at the interface between the glass cloth and the resin, it is preferred to provide a glass cloth that has excellent aesthetic quality and a lower value than the bulk dielectric loss tangent.

According to a preferred mode of the glass cloth of the embodiment, it is possible to improve the aesthetic quality by a method which produces stable dispersion in water even with surface treatment agents that have poor dispersibility in and/or compatibility with water (such as certain silane coupling agents). This helps to provide a glass cloth with a lower dielectric loss tangent as a glass cloth, compared to the dielectric loss tangent for the glass bulk, and helps to reduce increase in the dielectric loss tangent of the glass cloth with time even without special packaging. It also becomes easier to provide a glass cloth with excellent soldering heat resistance for resin substrates.

### [Dielectric loss tangent]

### (Dielectric loss tangent of glass cloth)

The glass cloth of the embodiment preferably has a dielectric loss tangent of 0.0020 or lower at 10 GHz. Such a glass cloth can provide a prepreg and printed circuit board with improved dielectric characteristics. From the viewpoint of improving the dielectric characteristics, the dielectric loss tangent of the glass cloth at 10 GHz is preferably 0.0015 or lower, 0.0010 or lower, 0.0007 or lower, 0.0006 or lower, 0.0005 or lower, 0.0004 or lower, or 0.0003, 0.0002, 0.00019, 0.00018, 0.00017, 0.00016, 0.00015, 0.00014, 0.00013, 0.00012 or 0.00011 or lower. The dielectric loss tangent of the glass cloth may be greater than zero.

### (Method of measuring dielectric loss tangent)

For the glass cloth of the embodiment, the dielectric loss tangent at 10 GHz is measured by a method using a split cylinder resonator (resonance-based method), and specifically by the method described in the Examples.

This method aids convenient and precise measurement, compared to conventional measuring methods in which the dielectric characteristic is evaluated by fabricating a substrate as the measuring sample. Without being limited to any particular theory, it is thought that the reason is that resonance methods are suited for evaluation in the high frequency range, and especially for evaluation of low loss materials.

Methods known for evaluating dielectric characteristics, other than resonance methods, include the lumped-constant method and reflection-transmission method. In the lumped-constant method, however, the measuring sample must be sandwiched between two electrodes to form a condenser, and this results in a more complex operation. When a low loss material is evaluated by the reflection-transmission method, the matching property of the measuring port has a major effect on measurement, and it has therefore been difficult to evaluate the dielectric loss tangent of measuring samples with high precision.

The resonance method, and specifically the method described in the Examples, therefore tends to allow more convenient and precise measurement of the dielectric loss tangent of a glass cloth.

For a glass cloth intended for use in a printed circuit board, and especially a glass cloth to be used in a printed circuit board for high-speed communication, the measuring device preferably has a prescribed range for measurement of the dielectric characteristic. For example, for measurement of the permittivity (Dk) and dielectric loss tangent (Df), the measuring device preferably has a measurable range for Dk = 1.1 Fm⁻¹ to 50 Fm⁻¹ and Df = 1.0 × 10⁻⁶ to 1.0 × 10⁻¹, more preferably it has a measurable range for Dk = 1.5 Fm⁻¹ to 10 Fm⁻¹ and Df = 1.0 × 10⁻⁵ to 5.0 × 10⁻¹, and even more preferably it has a measurable range for Dk = 2.0 Fm⁻¹ to 5 Fm⁻¹ and Df = 5.0 × 10⁻⁵ to 1.0 × 10⁻².

The measurable frequency by the measuring device for measurement of the dielectric characteristic is preferably 10 GHz or greater. A measurable frequency of 10 GHz or greater will facilitate evaluation of the properties in the frequency band range, and especially the properties in the frequency band range expected to be actually used by the glass cloth for a printed circuit board for high-speed communication.

The measurement area for the dielectric characteristic is preferably 10 mm² or greater, more preferably 15 mm² or greater and even more preferably 20 mm² or greater. This will help to increase the reliability of the measurement result, making it easier to satisfactorily judge whether or not the measurement result is within a preset reference value.

The thickness of the measuring sample is preferably 3 µm to 300 µm, more preferably 5 µm to 200 µm and even more preferably 7 µm to 150 µm.

### (Bulk dielectric loss tangent)

For a glass cloth of the embodiment, the bulk dielectric loss tangent of the glass starting material composing the glass cloth at 10 GHz is measured by a method using a split cylinder resonator (resonance method), and specifically by the method described in the Examples. The glass starting material may be glass yarn, glass filaments or glass feedstock, for example.

The bulk dielectric loss tangent at 10 GHz is preferably 0.002 or lower, more preferably 0.0015 or lower, even more preferably 0.001 or lower, yet more preferably 0.0005 or lower and most preferably 0.0004 or 0.0002 or lower. This will aid in exhibiting the effect of the present disclosure.

### (Method of controlling dielectric loss tangent of glass cloth)

The dielectric loss tangent of the glass cloth can be controlled, for example, by:
a method of removing degradation products and residue present on the glass yarn surfaces, or
a method of surface treatment of the glass yarn with a surface treatment agent capable of lowering the dielectric loss tangent of the glass cloth.

Examples of degradation products and residues include the following (i) and (ii):
(i) degradation products obtained by thermal oxidation of a sizing agent that physically adheres to a glass surface,
(ii) residue or modified residue of the surface treatment agent which remains physically adhering onto the glass surface without forming chemical bonds, even after washing.

### (Difference between dielectric loss tangent and bulk dielectric loss tangent)

In the glass cloth of the embodiment, the difference (dielectric loss tangent - bulk dielectric loss tangent) is less than 0.00000. Such a relationship is achieved when the bulk dielectric loss tangent is more than 0.00000 larger than the dielectric loss tangent. The methods for measuring the dielectric loss tangent and bulk dielectric loss tangent, and the method for controlling them, are as described above.

From the viewpoint of more easily exhibiting the effect of the disclosure, the difference (dielectric loss tangent - bulk dielectric loss tangent) is preferably -0.00002 or less, more preferably -0.00003 or less, even more preferably -0.00004 or less, yet more preferably -0.00005 or less, especially preferably -0.00006 or less, even yet more preferably -0.00007 or less and most preferably -0.00008 or less. The dielectric loss tangent of the glass cloth may be greater than -0.0002.

### [Glass yarn]

The glass yarn may be composed of multiple glass filaments. A glass cloth can be produced by weaving glass yarn as warp yarn and weft yarn.

### [Average filament diameter]

The average filament diameter of the glass filaments is preferably 2.5 to 9.0 µm, more preferably 2.5 to 7.5 µm, even more preferably 3.5 to 7.0 µm, yet more preferably 3.5 to 6.0 µm and most preferably 3.5 to 5.0 µm.

### [Pick density]

The pick density of the glass yarn (warp yarn and weft yarn) composing the glass cloth is preferably 10 to 120/inch (= 10 to 120/25.4 mm), more preferably 40 to 100/inch and even more preferably 40 to 100/inch.

### [Basis weight]

The basis weight of the glass cloth is preferably 8 to 250 g/m², more preferably 8 to 100 g/m², even more preferably 8 to 80 g/m² and most preferably 8 to 50 g/m².

### [Glass feedstock]

Glass cloths used in prepregs (laminated sheets) have conventionally been glass starting materials known as E glass (non-alkaline glass). The glass cloth of the embodiment, however, may be a glass starting material such as L glass, NE glass, D glass, L2 glass, T glass, silica glass or quartz glass, for example. From the viewpoint of excellent dielectric characteristics, it is preferred to use a glass starting material such as L glass, L2 glass, silica glass or quartz glass, among which silica glass and quartz glass are especially preferred. From the viewpoint of increasing the dimensional stability of a laminated sheet comprising the glass cloth, it is preferred to use a glass starting material such as S glass, T glass, silica glass or quartz glass, with silica glass and quartz glass being especially preferred.

The silicon (Si) content of the glass yarn composing the glass cloth is preferably 95.0 to 100 mass% or 99.0 to 100 mass%, more preferably 99.5 to 100 mass% and even more preferably 99.9 to 100 mass%, in terms of silicon dioxide (SiO₂). Particularly preferred for the SiO₂ composition of the glass yarn composing the glass cloth is a range of greater than 99.9 mass%. If the Si content is 95.0 mass% or greater it will be easier to ensure the dielectric characteristic of the glass cloth and the dimensional stability of the laminated sheet.

### [Woven structure]

The woven structure of the glass cloth may be a plain weave, mat weave, satin weave or twill weave, for example, with a plain weave structure being more preferred.

### [Surface treatment agent (surface treatment solution)]

The surface treatment solution may comprise a surface treatment agent. The surface treatment for the embodiment is carried out by a method using a surface treatment solution, for example.

It has been recognized in the prior art that using an ordinary surface treatment agent (for example, a common silane coupling agent) for surface treatment of a glass cloth increases the dielectric loss tangent.

As a result of investigation by the present inventors, it was found that when a glass surface is surface-treated with a highly hydrophobic surface treatment agent (for example, a highly hydrophobic silane coupling agent), moisture present in the storage environment is less likely to be adsorbed onto the glass surface, and as a result, increase in the dielectric loss tangent of the glass cloth with time can be easily minimized even without using special packaging.

A "highly hydrophobic surface treatment agent (highly hydrophobic silane coupling agent)", for the purpose of the disclosure, is defined as a state in which, when an aqueous solution obtained by mixing a surface treatment agent (silane coupling agent) to a concentration of 0.8 mass% in a 0.3 mass% aqueous acetic acid solution has been stirred for 3 hours at room temperature (25°C), the surface treatment agent (silane coupling agent) neither dissolves nor is evenly dispersed in the aqueous solution, and for example, the surface treatment agent (silane coupling agent) separates as oil droplets or an oil film in the aqueous solution.

### (Molecular weight)

The molecular weight of the surface treatment agent (for example, the molecular weight of the silane coupling agent), is preferably 250 to 1000, more preferably 270 to 800, even more preferably 300 to 750 and most preferably 350 to 700.

When two or more different surface treatment agents (for example, silane coupling agents) are used, the weighted average value of the molecular weight based on the mass of each surface treatment agent is preferably within the range specified above, and more preferably all of the molecular weights of the surface treatment agents used are within the range specified above.

For example, when surface treatment agents are prepared to 0.5 mass% and 1.0 mass% for silane coupling agents having molecular weights of 300 and 500, the weighted average value is calculated by the following formula:$Weighted average value = \left\{\left(300\times 0.5\right)/\left(0.5+1.0\right)\right\} + \left\{\left(500\times 1.0\right)/\left(0.5+1.0\right)\right\} = 433 .$

### (Silane coupling agent)

The surface treatment agent of the embodiment preferably comprises a silane coupling agent.

That is, the glass yarn (or glass filaments) composing the glass cloth are preferably surface-treated with a silane coupling agent.

The surface treatment agent preferably comprises a silane coupling agent represented by the following formula (1):

X₃₋ₙSiYₙ (1)

(where each X is independent and may comprise a different organic functional group, being each composed of a functional group having a total of two or more carbonyl and unsaturated carbon double bonds, each Y independently is an alkoxy group, and n is an integer of 1 to 3). This will lower the difference between the dielectric loss tangent of the glass cloth and the bulk dielectric loss tangent of the glass (dielectric loss tangent - bulk dielectric loss tangent) to less than 0.00000, and will help to reduce increase in the dielectric loss tangent of the glass cloth with time.

The silane coupling agent preferably comprises in the molecule at least one group selected from the group consisting of epoxy, amino, acryloyl and methacryloyl groups. For example, from the viewpoint of helping to increase adhesiveness with resins, X preferably comprises at least one group selected from the group consisting of epoxy, amino, aromatic vinyl, acryloyl and methacryloyl groups.

For Y, the alkoxy group is preferably an alkoxy group of 1 to 5 carbon atoms (1, 2, 3, 4 or 5 carbon atoms), from the viewpoint of stability during surface treatment of the glass cloth.

The silane coupling agent used in the surface treatment agent may be a silane coupling agent represented by formula (1), either alone or as a combination of multiple different types. For example, two or more different silane coupling agents with different X values may be used in admixture.

Examples of silane coupling agents represented by general formula (1) include:
4-(trimethoxysilyl)phenyl 2-methyl-2-propenoate,
1-[2-(trimethoxysilyl)ethyl]pentyl 2-methyl-2-propenoate, [4-[2-(trimethoxysilyl)ethyl]phenyl]methyl 2-propenoate,
N-2-propen-1-yl-N-[3-(trimethoxysilyl)propyl]-2-oxiranemethanamine,
3-(ethenyloxy)-2-[(trimethoxysilyl)oxy]propyl 2-propenoate,
6-[[[3-(trimethoxysilyl)propyl]amino]carbonyl]-2-naphthalenyl 2-methyl-2-propenoate,
3-[2-(trimethoxysilyl)ethyl]tricyclo[3.3. 1.1^{3,7}]dec-1-yl 2-methyl-2-propenoate,
4'-[(4-methylphenyl)[4-[2-(trimethoxysilyl)ethyl]phenyl]amino][1,1'-biphenyl]-4-yl 2-methyl-2-propenoate,
silane, trimethoxy[3-(7-oxabicyclo[4.1.0]hept-3-ylmethoxy)propyl],
1,3-bis(2-oxiranylmethyl)-5-[3-(trimethoxysilyl)propyl]-1,3,5-triazine-2,4,6(1H,3H,5H)-trione and
N¹-[10-(trimethoxysilyl)decyl]-1,3-benzenedimethanamine.

The silane coupling agent used may adjusted as appropriate depending on the dielectric loss tangent of the glass cloth before surface treatment and the matrix resin used in the resin substrate. Naturally, the silane coupling agent represented by formula (1) may be used together with a silane coupling agent other than one represented by formula (1).

It is preferred, however, to use two or more silane coupling agents represented by formula (1) above which have different molecular weights. Using two or more silane coupling agents with different molecular weights will tend to increase the treatment agent density on the glass surface, resulting in even greater reactivity with the matrix resin.

### [Average degree of opening of glass cloth]

The average degree of opening of the glass cloth is preferably 38% or greater, or greater than 40%, more preferably greater than 43%, even more preferably greater than 46%, greater than 50%, greater than 53%, greater than 56% or greater than 60%, and most preferably greater than 65%. If the average degree of opening of the glass cloth is 38% or greater, it will be easier to prevent residue of air bubbles (voids) in the glass yarn bundle when the resin substrate is fabricated, thus helping to prevent adverse effects on the soldering heat resistance or insulating reliability.

Since the silane coupling agent represented by formula (1) has relatively strong intermolecular forces and thus acts more readily, the impregnating property of the matrix resin in the glass cloth tends to be less advantageous than a silane coupling agent that is not represented by formula (1). Consequently, a glass cloth that has been surface-treated with a silane coupling agent represented by formula (1) preferably has an average degree of opening of 38% or greater, or greater than 40%, from the viewpoint of adequately obtaining an effect of improving the insulating reliability.

### [Ignition loss value of glass cloth ]

From the viewpoint of helping to lower the dielectric loss tangent of the glass cloth, the ignition loss value of the glass cloth is preferably 0.01 to 0.5 mass%, 0.01 to 0.4 mass% or 0.01 to 0.3 mass%, more preferably 0.02 to 0.25 mass%, even more preferably 0.03 to 0.22 mass%, yet more preferably 0.03 to 0.17 mass% and most preferably 0.04 to 0.15 mass%. If the ignition loss value is 0.01 mass% or greater it will be easier to ensure adhesiveness between the resin and glass cloth in the obtained prepreg. This will help ensure heat resistance and insulating reliability of fabricated printed circuit boards. If the ignition loss value of the glass cloth is 0.5 mass% or lower, it will be easier to avoid a condition in which a surface treatment agent (or its residue) that is physically adhering to the glass cloth surface without forming chemical bonds, or a surface treatment agent (or its residue) that cannot be reduced from the glass cloth surface by water washing, and/or any modified form of the same, is present in large amounts on the glass cloth surface. This will facilitate obtaining a low dielectric loss tangent for the glass cloth.

### [White spots on glass cloth]

A surface-treated glass cloth will sometimes be found to have an outer appearance with white spots. Such white spots tend to repel from the matrix resin used for prepreg fabrication, and can thus cause defects in outer appearance of the obtained prepreg.

The cause of such white spots has been considered unknown in the prior art.

However, the present inventors have demonstrated that one cause of white spots is aggregates or modified aggregates of a highly hydrophobic surface treatment agent (for example, a highly hydrophobic silane coupling agent).

In particular, the present inventors have shown that the silane coupling agent represented by formula (1) has relatively strong hydrophobicity and therefore tends to generate aggregates, and that when the solvent in the surface treatment solution comprises water, the frequency of white spot generation in the surface-treated glass cloth tends to increase (for example, with a rate of 10.0/m² or greater).

In order to minimize white spots, suitable methods include:
mixing the surface treatment solution in a specific manner,
carrying out temperature control and pH control of the surface treatment solution, and
filtering the surface treatment solution to remove the aggregates in the surface treatment solution.

The frequency of white spot generation in the glass cloth is preferably 7.0/m² or lower, more preferably 4.0/m² or lower, even more preferably 2.0/m² or lower or 0.1/m² or lower, and most preferably 0.05/m² or lower. This will help to obtain a prepreg with an excellent outer appearance. The frequency of white spot generation in the glass cloth may be greater than 0/m².

### [Method for producing glass cloth]

One aspect of the embodiment is a method for producing the glass cloth of the embodiment.

The production method of the embodiment comprises:
a weaving step in which glass yarn is woven to obtain a glass cloth, and
a surface treatment step in which the glass yarn is subjected to deoiling treatment, and the glass yarn is then surface-treated with a surface treatment solution,
wherein the dielectric loss tangent of the glass cloth at 10 GHz after surface treatment is lower than the dielectric loss tangent of the glass cloth at 10 GHz before surface treatment.

The production method of the embodiment may optionally comprise the following steps:
a step of heating glass yarn to reduce the amount of fiber sizing agent adhering to the glass yarn (heat deoiling step),
a step of washing the glass yarn (finishing washing step), and/or
a step of opening the glass yarn (opening step).

One or more from among the surface treatment step, opening step and finishing washing step may be carried out on the glass yarn before the step of weaving the glass yarn to obtain a glass cloth (weaving step), or any of the steps may be carried out on the glass cloth after the weaving step. The order of the heat deoiling step, surface treatment step, opening step and finishing washing step may also be switched. When a washing step is carried out after the weaving step, high-pressure water spraying may be used for the washing step, so as to simultaneously carry out the opening step. The composition of the glass cloth will generally not change before and after opening.

### [Heat deoiling step]

Heating the glass yarn in this step can reduce, and preferably remove, the fiber sizing agent and its residue, or their modified forms, which may be adhering onto the glass yarn. By carrying out a heat deoiling step it is possible to form a surface treatment layer on the surface of glass yarn (glass filaments) while reducing organic materials that can potentially increase the dielectric loss tangent, thus facilitating formation of a glass cloth with an excellent dielectric characteristic.

The means for heat deoiling may be any known means (such as heating means, a heating medium, a heating mechanism, a heating apparatus or a heating part).

One known mode for the heat deoiling step is a method of heating a glass cloth at a temperature of 600 to 1600°C.

If a glass cloth greige with a glass yarn softening point of 900°C or higher is heated in a temperature range of 600 to 1600°C in the heat treatment step, it will be easier to minimize damage to the glass cloth and to reduce the dielectric loss tangent of the glass cloth. From the viewpoint of inhibiting increase in the dielectric loss tangent of the glass cloth with time, it is preferred to fully dehydrate and condense the silanol groups on the glass surface, to an extent that does not adversely affect the subsequent surface treatment step. By reducing the silanol groups on the glass surface to below a certain level it is possible to reduce adsorption of moisture in the air, and thus more easily exhibit the effect of the disclosure.

From the viewpoint of satisfactorily obtaining the effect of the disclosure, the heat deoiling temperature is preferably 700 to 1500°C, more preferably 800 to 1400°C, even more preferably 900 to 1300°C and most preferably 1000 to 1200°C. If the heat deoiling temperature is 600°C or higher it will be easier to effectively remove sizing agent adhering to the glass cloth greige, thus facilitating formation of a glass cloth with an excellent dielectric characteristics. If the heat deoiling temperature 1600°C or lower, it will be easier to inhibit devitrification of the glass, thus helping to prevent reduction in the strength of the glass cloth.

The heating time is preferably 1 hour or less or 30 minutes or less, more preferably 15 minutes or less and even more preferably 5 minutes or less. Heat treatment of the glass cloth at high temperature for a sufficient period of time will tend to cause dehydrating condensation reaction of the silanol groups on the glass surface. The heating time may be 1 second or longer, 5 seconds or longer, 10 seconds or longer or 15 seconds or longer, for example, from the viewpoint of effectively removing the sizing agent.

When heat deoiling of the glass cloth is carried out in a closed system, the glass cloth is preferably placed in a heating furnace from the viewpoint of achieving suitable heating with the heating means. From the viewpoint of storage space, and a more efficient heating range, the glass cloth is preferably heated while stored as a roll. From the viewpoint of increasing efficiency for removal of organic matter and the viewpoint of shortening the removal time for organic matter, the heating is preferably carried out while conveying the glass cloth in the heating furnace. The glass cloth may be conveyed by a combination of an unwinding mechanism and a winding mechanism, for example.

When heat deoiling of the glass cloth is carried out in an open system, heating is preferably carried out while the glass cloth is conveyed, from the viewpoint of ensuring the area to be heated. The glass cloth may be conveyed by a combination of an unwinding mechanism and a winding mechanism, for example.

The mode used for the heat deoiling step is not limited to the one described above.

Another example for the heat deoiling step is:
a method of heating under conditions such that the heating amount is 450 (°C·h) or higher, as represented by: heating temperature (°C) of 100°C or higher (but with a maximum heating temperature of 100 to 600°C) × heating time (h), in a vacuum or in a gas with a dew point of 15°C or lower.

### (Heating means)

The heating means may be, for example, a heating furnace, electric heater or burner, with a gas-operated single radiant tube burner or electric heater being preferred. Multiple different heating means may also be combined.

From the viewpoint of efficiently removing the organic matter adhering to the glass cloth surface, a continuous system in which the glass cloth is heated while continuously passing it through a heating furnace, is preferred over a batch system in which the glass cloth wound around a winding core is heated at a specified ambient temperature. More preferred is a system that employs washing water with a low metal ion content, such as reverse osmosis (RO) water or ion-exchanged water, and that allows continuous washing of the glass cloth.

If heat deoiling of the glass cloth is carried out at 700°C or higher when sodium ion adhering to the glass cloth is above a specified amount, this may lower the tensile strength of the glass cloth due to devitrification of the quartz glass. However, if the glass cloth is washed with water having a sodium ion content of 20 ppm or lower before heat deoiling, in order to prevent devitrification, then it becomes easier to reduce the amount of sodium ion on the glass surface, which can help prevent devitrification of the quartz glass even when heat deoiling is carried out at 700°C or higher. Maintaining the strength of the glass cloth after heat deoiling can help prevent formation of wrinkles in and/or damage to the glass cloth during the surface treatment step.

From the viewpoint of satisfactorily obtaining the effect of the disclosure, the sodium ion content of the water used for washing may be 18 ppm or lower, 15 ppm or lower, 12 ppm or lower, 10 ppm or lower or 7 ppm or lower. The sodium ion content is preferably 0 ppm, but it may be above 0.

The means for washing the glass cloth using water with a sodium ion content of no greater than 20 ppm may be any known washing method, so long as it allows the sodium ions on the glass surface to be removed. For example, it may be a method using ultrasonic waves (for example, a method using an ultrasonic transducer), a method using spraying (for example, high-pressure spraying), or a method using water vapor spraying. From the viewpoint of allowing cost-effective processing, it is preferred to immerse the glass cloth in a water tank storing the washing water (water with a sodium ion content of 20 ppm or lower), and then to remove the excess washing water with a squeeze roller, and dry the glass cloth. The immersion time in this case may be 2 seconds or longer, 5 seconds or longer, 10 seconds or longer or 15 seconds or longer, and 120 seconds or less, 90 seconds or less, 60 seconds or less or 45 seconds or less, for example.

The method for producing water with a sodium ion content of 20 ppm or lower may be a known method. For example, a method such as filtration using an RO membrane or deionization using an ion exchange resin may be employed. The phrase "water with a sodium ion content of 20 ppm or lower" allows for the presence of other liquid components (such as non-water liquids) in ranges that do not interfere with the effect of the invention.

From the viewpoint of facilitating dehydrating condensation reaction of the silanol groups on the glass surface, the surrounding environment preferably contains as little moisture as possible during the period in which the temperature of the glass cloth surface is lowered to 100°C or lower after heat deoiling, or in other words, it is preferred to reduce the amount of moisture in the surroundings during heat deoiling. Examples of known methods for reducing moisture in the surroundings during heat deoiling include: a method of introducing dry air into the heating furnace, a method of creating a vacuum in the furnace, and a method of introducing an inert gas such as nitrogen into the furnace. When heat deoiling treatment is carried out while conveying the glass cloth, it is preferred to use a method of introducing an inert gas such as nitrogen into the furnace.

### [Surface treatment step]

In the surface treatment step, a surface treatment solution comprising a surface treatment agent with a molecular weight of 200 or higher is used for treatment of the glass yarn.

The method of treating the glass yarn with the surface treatment solution (for example, a method of coating the surface treatment solution onto the glass yarn) may be:
(a) a method of conveying the glass cloth while dipping it into the surface treatment solution which is stored in a bath (hereunder referred to as "dipping method"), or
(b) a method of directly coating the surface treatment solution onto the glass cloth using a roll coater, die coater or gravure coater. When a dipping method is employed, the time for immersion of the glass cloth in the surface treatment solution is preferably selected to be between 0.5 seconds and 1 minute.

In the surface treatment step of the method of the embodiment, a specified surface treatment agent, and especially a specified silane coupling agent (according to one aspect, a silane coupling agent is advantageous from the viewpoint of lowering the dielectric loss tangent of the glass cloth) is used for surface treatment of the glass yarn. The silane coupling agent to be used in the method of the embodiment is one having higher hydrophobicity than most silane coupling agents.

As mentioned above, it has been demonstrated by the present inventors that when the solvent in the surface treatment solution comprises water, this tends to produce aggregates of the surface treatment agent, and additionally that when the solvent in the surface treatment solution comprises water, the frequency of white spot generation in the glass cloth after surface treatment also tends to increase.

The present inventors have found that with a specified surface treatment solution it is possible to reduce white spots in the glass cloth by carrying out the following measures (A) to (C).
(A) Addition of a solvent (for example, a weakly acidic mother liquor) to the surface treatment agent,
(B) control of the temperature and/or pH of the surface treatment solution during surface treatment,
(C) filtration of the surface treatment solution during surface treatment.

### (A) Preparation of surface treatment solution

Since common silane coupling agents have excellent compatibility with water and excellent dispersibility in water, they are prepared by adding small amounts of the silane coupling agent into weakly acidic water with a pH of about 3 to 5 while stirring.

In the method of the embodiment, however, a surfactant and a small amount of a solvent for hydrolysis of the silane coupling agent (the solvent being a 60% aqueous acetic acid solution, for example) may be added to a diluted solution obtained by diluting the surface treatment agent with a small amount of methanol, to obtain a pre-solution of the surface treatment agent. The solvent in the pre-solution is preferably added for hydrolysis of the alkoxide groups of the silane coupling agent, preferably with the amount of solvent added being adjusted according to the desired degree of hydrolysis. An aqueous solution prepared to pH 3 to 4 (also referred to herein as "mother liquor") may also be added to the pre-solution in small portions at a time while stirring, to allow uniform dispersion of the surface treatment agent in the aqueous solution. This will help prevent aggregates from forming in the surface treatment solution.

From the viewpoint of helping to inhibit generation of white spots, the content of the silane coupling agent with respect to the surface treatment solution is preferably in the range of 0.01 to 2.0 mass%, more preferably in the range of 0.01 to 1.8 mass%, even more preferably in the range of 0.02 to 1.5 mass%, yet more preferably in the range of 0.02 to 1.3 mass% and most preferably in the range of 0.02 to 1.0 mass%. If the silane coupling agent content exceeds 2.0 mass%, the amount of silane coupling agent adhering to the glass cloth will be excessive, tending to increase the dielectric loss tangent of the glass cloth. Moreover, since this results in a relatively larger number of silanol groups that are not bonded to glass, moisture in the air will be more readily adsorbed, thus tending to result in a higher dielectric loss tangent of the glass cloth with the passage of time. If the silane coupling agent content is less than 0.01 mass%, on the other hand, the amount of silane coupling agent adhering to the glass cloth will be too low, making reaction between the silane coupling agent and the matrix resin less likely to proceed to a sufficient extent, and tending to adversely affect the soldering heat resistance of the substrate.

The surfactant used may be a nonionic surfactant, anionic surfactant, cationic surfactant or amphoteric surfactant, and the composition and amount may be changed as appropriate depending on the type and amount of surface treatment agent. A different type of surfactant may also be used in combination.

The amount of surfactant is preferably 0.2 to 10 mass%, more preferably 0.4 to 9 mass%, even more preferably 0.6 to 8 mass% and most preferably 1 to 6 mass%, with respect to the surface treatment agent (for example, a silane coupling agent). If the amount of surfactant satisfies this range it will be easier to uniformly disperse the silane coupling agent.

Nonionic surfactants include glycerin fatty acid esters, sorbitan fatty acid esters, sucrose fatty acid esters, polyoxyethylene alkyl ethers, polyoxyethylene alkylphenyl ethers, polyoxyethylene polyoxypropylene glycols, polyethylene glycol fatty acid esters, polyoxyethylene sorbitan fatty acid esters and fatty acid alkanolamides.

Anionic surfactants include fatty acid monocarboxylic acid salts, polyoxyethylene alkyl ether carboxylic acid salts, N-acylsarcosine salts, N-acyl glutamates, dialkylsulfosuccinic acid salts, alkane sulfonates, alpha-olefin sulfonates, straight-chain alkyl benzenesulfonates, alkyl benzenesulfonates, naphthalene sulfonate-formaldehyde condensates, alkylnaphthalene sulfonates, N-methyl-N-acyltaurine salts, alkyl sulfates, polyoxyethylene alkyl ether sulfates, sulfuric acid ester salts of fats and oils, alkyl phosphates, polyoxyethylene alkyl ether phosphates and polyoxyethylene alkylphenyl ether phosphates.

Cationic surfactants include monoalkylamine salts, dialkylamine salts, trialkylamine salts, alkyltrimethylammonium chlorides and alkylbenzalkonium chlorides.

Amphoteric surfactants include 2-alkyl-N-carboxymethyl-N-hydroxyethyl imidazolinium betaine, alkyl betaines, fatty acid amidopropyl betaine, alkyldiethylenetriaminoacetic acids and alkylamine oxides.

### (B) Temperature control and/or pH control of surface treatment solution

From the viewpoint of reducing aggregates in the surface treatment solution, the temperature of the surface treatment solution during surface treatment is preferably controlled to 10 to 30°C, more preferably controlled to 13 to 27°C, even more preferably controlled to 15 to 25°C and most preferably controlled to 17 to 23°C.

During the surface treatment, the pH of the surface treatment solution may vary depending on impurities such as alkali metals present in trace amounts in the glass cloth. From the viewpoint of reducing aggregates in the surface treatment solution, the range of variation in the pH of the surface treatment solution is preferably small. During the surface treatment, the pH of the surface treatment solution is preferably controlled to 2.5 to 5.5, more preferably controlled to 2.8 to 5.2 and even more preferably controlled to 3.0 to 5.0. The method of controlling the pH to within the predetermined range may be, for example, a method of bubbling the carbon dioxide through the surface treatment solution.

Either or both the temperature control of the surface treatment solution and the pH control of the surface treatment solution may be carried out. From the viewpoint of satisfactorily inhibiting aggregates in the surface treatment solution, it is preferred to both control the temperature of the surface treatment solution and control the pH of the surface treatment solution.

Here, "control the temperature of the surface treatment solution" includes not only a procedure of raising and/or lowering the temperature of the surface treatment solution, but also a procedure of holding the temperature of the surface treatment solution at a predetermined value, and a procedure of detecting the temperature in order to confirm whether or not the temperature of the surface treatment solution is within a predetermined range.

Also, "control the pH of the surface treatment solution" includes not only a procedure of raising and/or lowering the pH of the surface treatment solution, but also a procedure of holding the pH of the surface treatment solution at a predetermined value, and a procedure of detecting the pH in order to confirm whether or not the pH of the surface treatment solution is within a predetermined range.

### (C) Filtration of surface treatment solution

From the viewpoint of reliably collecting aggregates in the surface treatment solution, the surface treatment solution is preferably filtered during surface treatment. The aggregates that may be generated in the surface treatment solution are preferably collected by filtration while circulating the surface treatment solution.

Filtration is preferably carried out in multiple stages from the viewpoint of increasing the collection efficiency for aggregates. For example, preferably the surface treatment solution is subjected to two-stage filtration in which the aggregates are removed in a first stage with a relatively coarse filter, and then re-filtered with a finer filter than the primary filter. Such multistage filtration can help prevent blocking of the filter, thus tending to avoid interruption during the fabrication process for the glass cloth.

### (Drying step)

The surface treatment step may further comprise:
a step of coating the surface treatment solution onto the glass yarn and then drying the solvent in the surface treatment solution (drying step).

In the drying step, the surface treatment agent is easily anchored to the surface of the glass yarn (the surfaces of the glass filaments), and in particular the surface treatment agent is easily anchored to the surface of each individual glass yarn (the surface of each individual glass filament). The method of drying the solvent may be a known method, such as a method of drying by heating, and specifically a method of drying by heating with hot air or electromagnetic waves.

The drying temperature is preferably 80°C or higher and more preferably 90°C or higher from the viewpoint of adequate reaction between the surface treatment agent and glass. The drying temperature is also preferably 300°C or lower and more preferably 180°C or lower from the viewpoint of preventing degradation of the organic functional groups of the surface treatment agent.

### [Fiber opening step]

The production method of the embodiment preferably has a fiber opening step after the surface treatment step.

The method of fiber opening in the fiber opening step may be, for example, a method of opening the glass cloth with spray water (high-pressure water opening), a Vibrowasher, ultrasonic water or a mangle. Lowering the tension applied to the glass cloth during fiber opening makes it easier to widen the width of the glass yarn and to achieve some degree of removal of the surface treatment agent that has not chemically bonded to the glass surface. In order to help prevent reduction in the tensile strength of the glass cloth caused by opening, it is preferred to carry out measures for reducing friction of contact members, and optimization and high coverage of the sizing agent, during weaving of the glass yarn.

### [Washing step]

The washing step (finishing washing step) may be any method that can reduce residue of the surface treatment agent or its modified forms, which have not formed chemical bonds on the glass filament surfaces, and for example, it may be a method of washing the glass yarn with an organic solvent. Carrying out a washing step will aid in adjusting the difference between the dielectric loss tangent and bulk dielectric loss tangent to within the prescribed range for the obtained glass cloth, even when using a glass starting material with a high silicon (Si) content, such as quartz glass.

The washing step is preferably carried out with a highly hydrophobic organic solvent in order to reduce the amount of residue, which is difficult to reduce with water, and it is preferably carried out by washing with an organic solvent having high affinity with the hydroxyl group-containing silane coupling agent residue.

The washing method may be a known method such as, for example, dipping or shower spraying, and if necessary the washing may be carried out while heating or cooling. In order to avoid re-attachment of the dissolved glass cloth, the excess solvent in the washed glass cloth is preferably reduced with a squeezing roller before finishing and drying. Examples of suitable organic solvents with high hydrophobicity include:
saturated straight-chain aliphatic hydrocarbons such as n-pentane, i-pentane, *n*-hexane, *i-*hexane, n-heptane, i-heptane, n-octane, i-octane, 2,2,4-trimethylpentane (isooctane), n-nonane, *i-*nonane, n-decane, i-decane and 2,2,4,6,6-pentamethylheptane (isododecane);
saturated cyclic aliphatic hydrocarbons such as cyclopentane, cyclohexane, methylcyclohexane, dimethylcyclohexane and ethylcyclohexane;
aromatic hydrocarbons such as benzene, toluene, xylene, ethylbenzene, diethylbenzene, trimethylbenzene and triethylbenzene; and
halogen solvents such as chloroform, dichloromethane and dichloroethane.

Organic solvents with high affinity for modified forms of surface treatment agents (such as silane coupling agents) include:
alcohols such as methanol, ethanol and butanol;
ketones such as acetone and methyl ethyl ketone;
ethers such as methyl ethyl ether and diethyl ether;
amides such as N,N-dimethylformamide and N,N-dimethylacetamide; and
dimethyl sulfoxide.

Preferred among these are aromatic hydrocarbons, alcohols and ketones, with methanol being more preferred, from the viewpoint of facilitating adjustment of the difference between the dielectric loss tangent and bulk dielectric loss tangent of the obtained glass cloth within the specified range.

The production method of the embodiment preferably comprises a step of drying the washed glass cloth (a post-washing drying step), in order to reduce the organic solvent after washing, and from the viewpoint of facilitating reduction in the organic solvent by drying, the organic solvent used for washing preferably has a boiling point of no higher than 120°C. A known method such as heat drying or blast drying may be used for drying of the organic solvent.

When heat drying is carried out to reduce organic solvent in the post-washing drying step, hot air drying is preferred using low-pressure steam or heat transfer oil as the heat source, from the viewpoint of safety. The drying temperature is preferably at or above the boiling point of the washing solvent, and it is preferably no higher than 180°C from the viewpoint of inhibiting deterioration of the silane coupling agent.

### [Optional steps]

The production method of the embodiment may also comprise other optional steps in addition to those described above.

Other steps include, for example, a step of working the glass cloth into a slit shape (slitting step).

### (Inspection step or measuring step)

Additional steps may also include a step of inspecting white spots on the glass cloth. The production method of the embodiment comprising the steps described above facilitates formation of a glass cloth according to the embodiment.

### [Prepreg]

A prepreg of the embodiment comprises a glass cloth, a matrix resin and an inorganic filler. The prepreg of the embodiment may be obtained using the glass cloth of the embodiment as the glass cloth. This provides a prepreg with excellent properties (for example, a prepreg with few voids).

The matrix resin used may be a thermosetting resin or a thermoplastic resin. A thermosetting resin and a thermoplastic resin may also be used in combination.

Examples of thermosetting resins include:
a) epoxy resins obtained by reacting a compound with an epoxy group and a compound with at least one group such as an amino, phenol, acid anhydride, hydrazide, isocyanate, cyanate or hydroxyl group that reacts with the epoxy group, without a catalyst, or reacting them with addition of a catalyst having reaction catalyzing activity, such as an imidazole compound, tertiary amine compound, urea compound or phosphorus compound, and curing the reaction product;
b) radical polymerization-type curing resins obtained by using a compound with at least one allyl, methacryl or acrylic group, and using a thermal decomposition-type catalyst or photodecomposition-type catalyst as a reaction initiator, with curing;
c) maleimide triazine resins obtained by reacting and curing a compound with a cyanate group and a compound with a maleimide group;
d) thermosetting polyimide resins obtained by reacting and curing a maleimide compound and an amine compound; and
e) benzoxazine resins obtained by crosslinked curing of a compound with a benzoxazine ring by thermal polymerization.

Examples of thermoplastic resins include polyphenylene ether, modified polyphenylene ether, polyphenylene sulfide, polysulfone, polyethersulfone, polyallylate, aromatic polyamides, polyether ether ketone, thermoplastic polyimides, insoluble polyimides, polyamideimide, LCP, polyesters and fluorine resins.

The prepreg may also comprise an inorganic filler. Examples of inorganic fillers include aluminum hydroxide, zirconium oxide, calcium carbonate, alumina, mica, aluminum carbonate, magnesium silicate, aluminum silicate, silica, talc, staple glass fibers, aluminum borate and silicon carbide. The inorganic filler may also be used together with a thermosetting resin.

### [Printed circuit board]

The printed circuit board of the embodiment comprises a prepreg. In particular, the printed circuit board of the embodiment comprises the prepreg of the embodiment as a prepreg. This provides a printed circuit board with excellent properties (for example, a printed circuit board with excellent insulating reliability).

### [Integrated circuit and electronic device]

An integrated circuit of the embodiment comprises a printed circuit board according to the embodiment. An electronic device of the embodiment also comprises a printed circuit board according to the embodiment. An integrated circuit or electronic device with excellent properties can thus be provided.

### EXAMPLES

The embodiment will now be explained using Examples and Comparative Examples. However, it is to be understood that the embodiment is not limited only to these Examples. Production, measurement and evaluation in the Examples and Comparative Examples were carried out by the following methods.

### [Thickness]

A micrometer was used according to JIS R 3420 7.10, carefully rotating the spindle for gentle contact parallel to the measuring surface, and reading off the scale after the ratchet tapped three times. JIS R 3420 specifies general test methods for products such as glass long fibers and glass cloths employing glass long fibers.

### [Basis weight]

The glass cloth was cut to a specified size to obtain a sample. The weight of the sample was divided by the sample area to determine the basis weight. The glass cloth was cut to a size of 10 cm × 10 cm to obtain a sample, and the weight was measured to calculate the basis weight (g/m²).

### [Equivalent thickness]

Since a glass cloth is a discontinuous surface composed of air and glass, the basis weight of each glass cloth was divided by the glass density to calculate the equivalent thickness necessary for measurement by resonance. The formula for calculation is as follows:$Equivalent thickness \left(μm\right) = basis weight \left(g/{m}^{2}\right) \div glass density \left(g/{cm}^{3}\right) .$

### [Dielectric loss tangent]

The dielectric loss tangent of each glass cloth was measured according to IEC 62562. Specifically, a glass cloth sample taken at the size necessary for measurement with each split cylinder resonator was stored for 8 hours in a constant temperature and humidity oven at 23°C, 50% RH for humidification. Next, a split cylinder resonator (product of EM Lab) and an impedance analyzer (product of Agilent Technologies) were used to measure the dielectric characteristic at 10 GHz. The measurement was conducted 5 times for each sample, and the average value was calculated. The equivalent thickness was used as the thickness for each sample. Incidentally, IEC 62562 specifies a method of measuring the dielectric characteristics in the microwave band, of fine ceramic materials for dielectric substrates used primarily in microwave circuits.

### [Bulk dielectric loss tangent]

A 300 µm-thick glass plate was prepared having the same type and same composition as each glass cloth that had been measured for dielectric loss tangent. The thickness obtained by measurement of the glass plate thickness was used in measurement of the bulk dielectric loss tangent at 10 GHz, by the same method as for measurement of the dielectric loss tangent.

### [Difference in dielectric loss tangent (dielectric loss tangent - bulk dielectric loss tangent)]

The difference in dielectric loss tangent (dielectric loss tangent - bulk dielectric loss tangent) was determined based on the dielectric loss tangent and bulk dielectric loss tangent obtained by the methods described above.

### [Increase in dielectric loss tangent with time]

The dielectric loss tangent of a glass cloth can increase due to moisture present in its storage environment. A constant temperature and humidity chamber was used to store a glass cloth for 1 week in a high temperature, high humidity environment (40°C, 90% relative humidity), and the increase in the dielectric loss tangent with time before and after storage was determined (dielectric loss tangent after storage - dielectric loss tangent before storage).

### (Conditions)

Storage conditions: 40°C × 90% RH
Storage period: 1 week
Dielectric loss tangent: Measuring method as described in [Dielectric loss tangent] above

### [Ignition loss value]

The ignition loss value of the glass cloth was determined according to JIS R3420. Specifically, the glass cloth was dried under conditions with a temperature of 110°C ±5°C for a period of 60 minutes. It was then transferred to a desiccator and allowed to cool at room temperature for 20 minutes, after which the mass of the test piece was measured up to 0.1 mg units (A mg). The dried test piece was subjected to heat treatment under conditions with a temperature of 625°C ±20°C for a period of 20 minutes. It was then transferred to a desiccator and allowed to cool for 20 minutes, after which the mass of the test piece was measured up to 0.1 mg units (B mg). The ignition loss value was calculated by the following formula, and rounded to three decimal places.$Ignition loss value \left(%\right) = \left(A\left(mg\right)-B\left(mg\right)\right) / A \left(mg\right) \times 100$

### [Average filament diameter of glass yarn]

A cross-section of a bundle of 30 glass yarns taken at an arbitrary location in the glass yarns was observed with a scanning electron microscope, and the average value was calculated to determine the average filament diameter.

### [Average degree of opening]

The opening degree of the warp yarn of the glass cloth was calculated by the following formula: 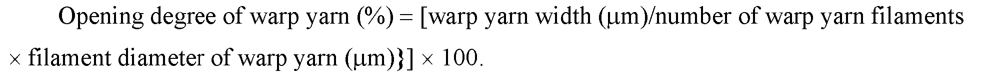 Opening degree of warp yarn (%) = [warp yarn width (µm)/number of warp yarn filaments × filament diameter of warp yarn (µm)}] × 100.

The opening degree of the weft yarn of the glass cloth was calculated by the following formula: 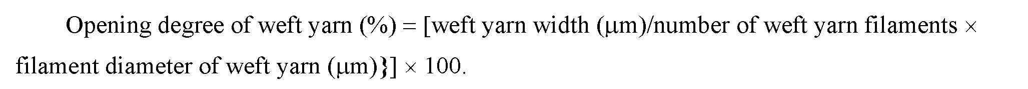 Opening degree of weft yarn (%) = [weft yarn width (µm)/number of weft yarn filaments × filament diameter of weft yarn (µm)}] × 100.

The calculated opening degree (%) of the warp yarn and opening degree (%) of the weft yarn were used to calculate the average degree of opening by the following formula: 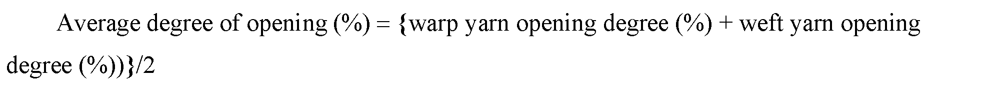 Average degree of opening (%) = {warp yarn opening degree (%) + weft yarn opening degree (%))}/2

### (Number of filaments for warp yarn and weft yarn)

For calculation of the average degree of opening, the numbers of filaments in the warp yarn and weft yarn were determined by observing a cross-sectional image of the glass yarn. Specifically, a cross-sectional image of glass yarn was taken as the warp yarn (or weft yarn), and the number of warp yarn (or weft yarn) filaments in the cross-sectional image was measured.

Image acquisition of the glass yarn and measurement of the number of filaments were repeated in the same manner, and the average value for 5 obtained measurements was used as the number of filaments of the warp yarn (or weft yarn).

### (Warp yarn width and weft yarn width)

For calculation of the average degree of opening, the warp yarn width and weft yarn width were determined by the following method .

First, five glass cloth test pieces with sizes of 70 mm in the warp direction and 70 mm in the weft direction were cut out from the glass cloth.

Each cut out test piece was observed using a macroscope from the vertical direction at 100x magnification. The widths of 250 warp yarns (or weft yarns) were measured randomly for each test strip, and the average value for the widths of the 250 warp yarns (or weft yarns) was calculated. The calculated average value was used as the warp yarn width (or weft yarn width).

### [Glass cloth P]

The warp yarn and weft yarn used were composed of glass yarn with a SiO₂ composition of greater than 99.9 mass%. Specifically, the warp yarn and weft yarn used were each glass yarn with an average filament diameter of 5.0 µm, 100 filaments and 1.0 Z twisting. An air jet loom was used for weaving of a 2000 m glass cloth with a plain weave structure, having a woven density of 66/25 mm warp yarns and 68/25 mm weft yarns, and a cloth width of 1300 mm. The bulk dielectric loss tangent at 10 GHz for the glass composing the glass yarn was 0.00020.

### [Glass cloth Q]

The warp yarn and weft yarn used were composed of glass yarn with a SiO₂ composition of greater than 99.9 mass%. Specifically, the warp yarn and weft yarn used were each glass yarn with an average filament diameter of 5.0 µm, 200 filaments and 1.0 Z twisting. An air jet loom was used for weaving of a 2000 m glass cloth with a plain weave structure, having a woven density of 54/25 mm warp yarns and 54/25 mm weft yarns, and a cloth width of 1300 mm. The bulk dielectric loss tangent at 10 GHz for the glass composing the glass yarn was 0.00020.

### [Glass cloth R]

The warp yarn and weft yarn used were composed of glass yarn with a SiO₂ composition of greater than 99.9 mass%. Specifically, the warp yarn and weft yarn used were each glass yarn with an average filament diameter of 4.0 µm, 50 filaments and 1.0 Z twisting. An air jet loom was used for weaving of a 2000 m glass cloth with a plain weave structure, having a woven density of 95/25 mm warp yarns and 95/25 mm weft yarns, and a cloth width of 1300 mm. The bulk dielectric loss tangent at 10 GHz for the glass composing the glass yarn was 0.00020.

### [Preparation of surface treatment solution]

The surface treatment solution was prepared by the following procedure 1) to 5).
1) The silane coupling agent was weighed out.
2) Methanol in the same amount as weighed out in 1) above was mixed with the silane coupling agent as weighed out in 1) above to prepare a silane coupling agent solution.
3) The silane coupling agent solution and 0.8 mass% of a polyoxyethylene alkyl ether were mixed with the silane coupling agent, and the mixture was stirred. After stirring for 1 minute, an aqueous acetic acid solution (60 mass% concentration) at 20 mass% with respect to the silane coupling agent was added to the silane coupling agent solution. The silane coupling agent was thus hydrolyzed.
4) A mother liquor of the aqueous acetic acid solution (pH = 3 to 4) was prepared. The silane coupling agent solution (pre-solution) obtained in 3) above was stirred for 15 minutes at room temperature (20 to 25°C). The mother liquor was added dropwise to the silane coupling agent solution while stirring to disperse the silane coupling agent. The drip volume (dropping rate) of the mother liquor was set so that dropping of the total amount of the mother liquor was complete by 10 minutes.
5) After completing 4), the silane coupling agent solution was stirred for 2 hours at room temperature (20 to 25°C) to obtain a surface treatment solution.

According to one aspect, the "solvent" in the "step of adding a solvent to the surface treatment agent to prepare a surface treatment solution" is the aforementioned mother liquor. One example for the mother liquor is a weakly acidic aqueous solution with a pH of 3 to 4, added to disperse the hydrolyzed silane coupling agent.

### [Examples and Comparative Examples]

### (Example 1)

The glass cloth P was washed with ion-exchanged water and then dried. This removed the alkali metal ions adhering to the glass cloth surface. The glass cloth was then conveyed in a furnace with the preset temperature adjusted to 1000°C, while heat deoiling for 5 minutes (heat deoiling step). The furnace interior was adjusted to a nitrogen atmosphere for the heat deoiling.

A surface treatment solution was prepared by the method described above, using 4-(trimethoxysilyl)phenyl 2-methyl-2-propenoate (CAS NO: 2097368-37-9, molecular weight = 282.36, silane coupling agent A) as the silane coupling agent, to a silane coupling agent concentration of 0.4 mass% in the surface treatment solution.

The heated deoiled glass cloth was immersed in the obtained surface treatment solution. The excess surface treatment solution was then squeezed out with an NBR rubber roll at a pressure of 0.3 MPa. The glass cloth was then heat dried at 130°C for 1 minute to anchor the silane coupling agent to the surface of the glass cloth.

For this Example, temperature control (such as cooling) was carried out during surface treatment of the glass cloth, keeping the temperature of the surface treatment solution in the range of 17 to 23°C. During surface treatment of the glass cloth, carbon dioxide was bubbled through the surface treatment solution to keep the surface treatment solution pH in the range of 3.0 to 4.0.

For this Example, the surface treatment solution used for surface treatment of the glass cloth was filtered using an HDCII filter (product of Nihon Pall Ltd.). Specifically, first the surface treatment solution was passed through a filter with a pore size of 10 µm, and then the surface treatment solution was further passed through a filter with a pore size of 4.5 µm. Aggregates present in the surface treatment solution were thus collected. The filtered surface treatment solution was used for surface treatment of a glass cloth.

The surface-treated glass cloth was opened under high pressure using a spray nozzle, at a pressure of 3.0 kg/cm². Next, ultrasonic waves at a frequency of 25 kHz and an output of 0.50 W/cm² were irradiated in water for further opening treatment while reducing the excess silane coupling agent that had physically adhered onto the glass cloth. This was followed by heating at 130°C for 1 minute for drying. This produced 2000 m of a surface-treated glass cloth.

### (Example 2)

A glass cloth (2000 m) was obtained by the same method as Example 1, except that [4-[2-(trimethoxysilyl)ethyl]phenyl]methyl 2-propenoate (CAS NO: 141813-20-9, molecular weight = 310.42, silane coupling agent B) was used as the silane coupling agent.

### (Example 3)

A glass cloth (2000 m) was obtained by the same method as Example 1, except that 6-[[[3-(trimethoxysilyl)propyl]amino]carbonyl]-2-naphthalenyl 2-methyl-2-propenoate (CAS NO: 1537868-42-0, molecular weight = 417.53, silane coupling agent C) was used as the silane coupling agent.

### (Example 4)

A glass cloth (2000 m) was obtained by the same method as Example 1, except that 1,3-bis(2-oxiranylmethyl)-5-[3-(trimethoxysilyl)propyl]-1,3,5-triazine-2,4,6(1H,3H,5H)-trione (CAS NO: 1331829-87-8, molecular weight = 403.46, silane coupling agent D) was used as the silane coupling agent.

### (Example 5)

A glass cloth (2000 m) was obtained by the same method as Example 1, except that N¹-[10-(trimethoxysilyl)decyl]-1,3-benzenedimethanamine (CAS NO: 149048-51-1, molecular weight = 396.64, silane coupling agent E) was used as the silane coupling agent.

### (Example 6)

A surface-treated glass cloth (2000 m) was obtained by the same method as Example 1, except that 4'-[(4-methylphenyl)[4-[2-(trimethoxysilyl)ethyl]phenyl]amino][1,1'-biphenyl]-4-yl 2-methyl-2-propenoate (CAS NO: 1266672-96-1, molecular weight = 567.75, silane coupling agent F) was used as the silane coupling agent.

### (Example 7)

A glass cloth (2000 m) was obtained by the same method as Example 1, except that glass cloth Q was used instead of glass cloth P.

### (Example 8)

A glass cloth (2000 m) was obtained by the same method as Example 1, except that glass cloth R was used instead of glass cloth P.

### (Example 9)

A glass cloth (2000 m) was obtained by the same method as Example 3, except that surface treatment was carried out without filtration of the surface treatment solution.

### (Example 10)

A glass cloth (2000 m) was obtained by the same method as Example 1, except that the concentration of the surface treatment solution was adjusted to 0.2 mass% for silane coupling agent A and 0.2 mass% for silane coupling agent B, for a total of 0.4 mass%, and instead of opening the fibers with a spray nozzle, opening was carried out with ultrasonic waves at an output of 0.20 W/cm².

### (Example 11)

A glass cloth (2000 m) was obtained by the same method as Example 3, except that the surface treatment solution was not cooled even if the surface treatment solution temperature rose above 23°C, and carbon dioxide was not bubbled through even if the pH exceeded 4.0.

### (Comparative Example 1)

A surface-treated glass cloth (2000 m) was obtained by the same method as Example 1, except that the concentration of the surface treatment solution was adjusted to 0.9 mass%, and the heat deoiling temperature was changed to 700°C.

### (Comparative Example 2)

A surface-treated glass cloth (2000 m) was obtained by the same method as Example 1, except that the concentration of the surface treatment solution was adjusted to 2.5 mass%.

### (Comparative Example 3)

A glass cloth (2000 m) was obtained by the same method as Example 1, except that a silane coupling agent solution was added dropwise into the mother liquor of the stirred aqueous acetic acid solution to prepare the surface treatment solution, surface treatment of the glass cloth was carried out without filtration of the surface treatment solution, the surface treatment solution was not cooled even if the surface treatment solution temperature rose above 23°C, and carbon dioxide was not bubbled through even if the pH exceeded 4.0.

### [Frequency of white spot generation]

The frequency of white spot generation on the glass cloth surface was evaluated by irradiating a halogen lamp onto a glass cloth of at least A4 size (210 mm × 297 mm). For a sheet-like glass cloth, a halogen lamp was set directly above the glass cloth, and the number of white spots was determined while observing the glass cloth from different directions, calculating the frequency of white spot generation according to the following formula:$Frequency of white spot generation \left(/{m}^{2}\right) = number of white spots / \left\{glass cloth area\left({m}^{2}\right)\right\} .$

For a glass cloth roll, the number of white spots generated in the glass cloth was counted across a length of 2000 m while applying a tensile force of 100 N/1300 mm to the glass cloth during irradiation with a halogen lamp on a Roll-to-Roll examining table. The frequency of white spot generation was determined according to the following formula, based on the examining area and the number of white spots found during examination: 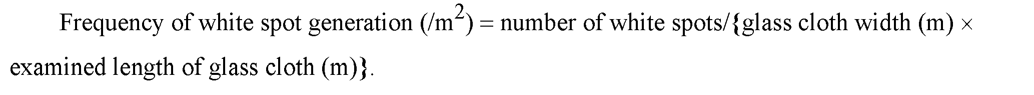 Frequency of white spot generation (/m2) = number of white spots/{glass cloth width (m) × examined length of glass cloth (m)}.

Fig. 1 is a photograph showing a "white spot", for this Example. Fig. 1(a) is a photograph showing at a location without a white spot, and Fig. 1(b) is a photograph showing a location with a white spot P.

For the Example, a "white spot" is defined as a defect where a white contour line is observed under UV light irradiation and the area enclosed by the contour line (the area including the contour line) is 0.8 cm² or greater. The outline here is circular, as an example.

The area enclosed by the contour line was calculated using known image analysis software.

### [Prepreg production method 1]

For production method 1, a polyphenylene ether resin was used as the starting material.

Specifically, 45 parts by mass of polyphenylene ether (Noryl SA9000, product of SABIC), 10 parts by mass of triallyl isocyanurate, 45 parts by mass of toluene and 0.6 parts by mass of 1,3-di(tert-butylisopropylbenzene) were added to a stainless steel container and the mixture was stirred at room temperature for 1 hour. A varnish was thus prepared.

The prepared varnish was impregnated into the glass cloths obtained in Examples 1 to 4 and 6 to 11 and Comparative Examples 1 to 3, and then dried at 130°C for 1 minute to obtain prepregs.

### [Prepreg production method 2]

For production method 2, an epoxy resin was used as the starting material.

Specifically, 80 parts by mass of a low-brominated bisphenol A-type epoxy resin, 20 parts by mass of a cresol-novolac-type epoxy resin, 2 parts by mass of dicyandiamide, 0.2 parts by mass of 2-ethyl-4-methylimidazole and 100 parts by mass of 2-methoxy-ethanol were mixed to prepare a varnish.

The prepared varnish was impregnated into the glass cloths obtained in Examples 4 and 5, and then dried at 130°C for 7 minutes to obtain prepregs.

### [Method of producing polyphenylene ether resin substrate]

The obtained prepreg was sampled to a size of 20 cm × 20 cm. Eight of the obtained samples were stacked, and a 12 µm-thick copper foil was further stacked on the top level and bottom level. The stack was then heated and pressed at 200°C, 40 kg/cm² for 120 minutes to fabricate a resin substrate.

### [Method of producing epoxy resin substrate]

The obtained prepreg was sampled to a size of 20 cm × 20 cm. Eight of the obtained samples were stacked, and a 12 µm-thick copper foil was further stacked on the top level and bottom level. The stack was then heated and pressed at 195°C, 40 kg/cm² for 120 minutes to fabricate a resin substrate.

### [Soldering heat resistance]

The top and bottom copper foils were removed from the resin substrate to obtain a laminated sheet. A total of ten 5 cm × 5 cm samples were cut out from the obtained laminated sheet. These were heated in a pressure cooker container at 133°C for 24 hours and caused to absorb water. Each water-absorbed laminated sheet was then immersed for 20 seconds in a solder bath at 288°C, and each of the 10 laminated sheet samples was visually examined for any blistering due to detachment at the glass cloth/resin interface.

Laminated sheet samples with blistering due to detachment at the glass cloth/resin interface were evaluated as "unacceptable", and the number of laminated sheet samples evaluated as "unacceptable" was recorded. A smaller number of recorded glass cloths indicates more excellent heat resistance.

The production conditions and evaluation results for the Examples and Comparative Examples are shown in the following table. The glass cloths of the Examples were successfully used to fabricate prepregs, printed circuit boards (resin boards), integrated circuits and electronic devices by common methods.

### [Table 1]

**Table 1**

| | | | Example 1 | Example 2 | Example 3 | Example 4 | Example 5 | Example 6 | Example 7 |
|---|---|---|---|---|---|---|---|---|---|
| Glass cloth type | | | P | P | P | P | P | P | Q |
| Heat deoiling step | Temperature | °C | 1000 | 1000 | 1000 | 1000 | 1000 | 1000 | 1000 |
| | Time | min | 5 | 5 | 5 | 5 | 5 | 5 | 5 |
| Surface treatment step | Surface treatment solution type | - | A | B | C | D | E | F | A |
| | Surface treatment solution preparation method | | Dropping of mother liquor into silane coupling agent | Dropping of mother liquor into silane coupling agent | Dropping of mother liquor into silane coupling agent | Dropping of mother liquor into silane coupling agent | Dropping of mother liquor into silane coupling agent | Dropping of mother liquor into silane coupling agent | Dropping of mother liquor into silane coupling agent |
| | Surface treatment solution filtration | | Yes | Yes | Yes | Yes | Yes | Yes | Yes |
| | Surface treatment solution temperature and pH control | | Yes | Yes | Yes | Yes | Yes | Yes | Yes |
| | Molecular weight of surface treatment solution (silane coupling agent) | | 282.36 | 310.42 | 417.53 | 403.46 | 396.64 | 567.75 | 282.36 |
| | Concentration | mass % | 0.4 | 0.4 | 0.4 | 0.4 | 0.4 | 0.4 | 0.4 |
| Physical properties | Thickness | µm | 34 | 34 | 34 | 34 | 34 | 34 | 47 |
| | Basis weight | g/m² | 25.5 | 25.7 | 25.6 | 25.4 | 25.5 | 25.4 | 40.3 |
| | Ignition loss value | % | 0.06 | 0.07 | 0.08 | 0.15 | 0.08 | 0.08 | 0.06 |
| | Average degree of opening | % | 58 | 60 | 61 | 58 | 59 | 61 | 58 |
| | Frequency of white spot generation | count/ m² | 0.01 | 0.01 | 0.01 | 0.01 | 0.01 | 0.01 | 0.01 |
| | (A) Dielectric loss tangent | - | 0.00013 | 0.00018 | 0.00011 | 0.00013 | 0.00013 | 0.00010 | 0.00013 |
| (B) Bulk dielectric loss tangent | | | 0.00020 | 0.00020 | 0.00020 | 0.00020 | 0.00020 | 0.00020 | 0.00020 |
| Dielectric loss tangent difference {(A)-(B)} | | | -0.00007 | -0.00002 | -0.00009 | -0.00007 | -0.00007 | -0.00010 | -0.00007 |
| Increase in dielectric loss tangent over time (× 10⁻⁵) | | | 0.5 | 0.8 | 0.3 | 0.5 | 0.5 | 0.1 | 0.5 |
| Soldering heat resistance | | | 0 | 0 | 0 | 0 | 0 | 0 | 0 |

### [Table 2]

**Table 2**

| | | | Example 8 | Example 9 | Example 10 | Example 11 | Comp. Example 1 | Comp. Example 2 | Comp. Example 3 |
|---|---|---|---|---|---|---|---|---|---|
| Glass cloth type | | | R | P | P | P | P | P | P |
| Heat deoiling step | Temperature | °C | 1000 | 1000 | 1000 | 1000 | 700 | 1000 | 1000 |
| | Time | min | 5 | 5 | 5 | 5 | 5 | 5 | 5 |
| Surface treatment step | Surface treatment solution type | - | A | C | A+B | C | A | A | A |
| | Surface treatment solution preparation method | | Dropping of mother liquor into silane coupling agent | Dropping of mother liquor into silane coupling agent | Dropping of mother liquor into silane coupling agent | Dropping of mother liquor into silane coupling agent | Dropping of mother liquor into silane coupling agent | Dropping of mother liquor into silane coupling agent | Dropping of silane coupling agent into mother liquor |
| | Surface treatment solution filtration | | Yes | No | Yes | Yes | Yes | Yes | No |
| | Surface treatment solution temperature and pH control | | Yes | Yes | Yes | No | Yes | Yes | No |
| | Molecular weight of surface treatment solution (silane coupling agent) | | 282.36 | 417.53 | 282.36 | 417.53 | 282.36 | 282.36 | 282.36 |
| | | | | | 310.42 | | | | |
| | | | | | Weighted average = 296.39 | | | | |
| | Concentration | mass% | 0.4 | 0.4 | 0.4 | 0.4 | 0.9 | 2.5 | 0.4 |
| Physical properties | Thickness | µm | 15 | 34 | 34 | 34 | 34 | 34 | 34 |
| | Basis weight | g/m² | 10.5 | 25.6 | 25.4 | 25.7 | 25.6 | 25.6 | 25.6 |
| | Ignition loss value | % | 0.07 | 0.08 | 0.08 | 0.08 | 0.30 | 0.52 | 0.08 |
| | Average degree of opening | % | 57 | 55 | 38 | 58 | 58 | 58 | 58 |
| | Frequency of white spot generation | count/m² | 0.01 | 3 | 0.01 | 1 | 0.01 | 10 | 15 |
| | (A) Dielectric loss tangent | - | 0.00013 | 0.00015 | 0.00014 | 0.00015 | 0.00026 | 0.00022 | 0.00014 |
| (B) Bulk dielectric loss tangent | | | 0.00020 | 0.00020 | 0.00020 | 0.00020 | 0.00020 | 0.00020 | 0.00020 |
| Dielectric loss tangent difference {(A)-(B)} | | | -0.00007 | -0.00005 | -0.00006 | -0.00005 | 0.00006 | 0.00002 | -0.00006 |
| Increase in dielectric loss tangent over time (× 10⁻⁵) | | | 0.5 | 0.8 | 0.6 | 0.8 | 3.9 | 2.3 | 0.7 |
| Soldering heat resistance | | | 0 | 3 | 2 | 2 | 0 | 8 | 10 |

With the Examples it was possible to provide glass cloths exhibiting excellent dielectric characteristics, having inhibited increase in the dielectric loss tangent with time, and exhibiting excellent soldering heat resistance for resin substrates fabricated using the glass cloths. With Comparative Examples 1 and 2, on the other hand, it was not possible to inhibit increase in the dielectric loss tangent with time, and with Comparative Example 3 it was not possible to obtain excellent soldering heat resistance.

### INDUSTRIAL APPLICABILITY

The present invention can be utilized in fields related to glass cloths and printed circuit boards (especially printed circuit boards for high-speed communication).

### REFERENCE SIGNS LIST

P: White spot

## Claims

1. A glass cloth formed by weaving glass yarn, wherein:
the glass cloth is surface-treated with a surface treatment agent, and
the difference between the dielectric loss tangent of the glass cloth at 10 GHz and the bulk dielectric loss tangent of the glass composing the glass yarn at 10 GHz (dielectric loss tangent - bulk dielectric loss tangent) is less than 0.00000, and
the number of white spots of the glass cloth is 10/m² or less.

2. A glass cloth according to claim 1, wherein the silicon (Si) content of the glass yarn is 95.0 to 100 mass% in terms of silicon dioxide (SiO₂).

3. A glass cloth according to claim 1 or 2, wherein the average degree of opening of the warp yarn and weft yarn of the glass cloth is greater than 40%, as calculated from their respective yarn widths.

4. A glass cloth according to claim 1 or 2, wherein the bulk dielectric loss tangent is 0.002 or lower.

5. A glass cloth according to claim 1 or 2, wherein the surface treatment agent comprises a silane coupling agent.

6. A glass cloth according to claim 5, wherein the molecular weight of the silane coupling agent is 250 to 1000.

7. A glass cloth according to claim 5, wherein the silane coupling agent comprises in the molecule at least one group selected from the group consisting of epoxy, amino, aromatic vinyl, acryloyl and methacryloyl groups.

8. A glass cloth according to claim 5, wherein the surface treatment agent comprises two or more silane coupling agents with different molecular weights.

9. A glass cloth according to claim 1 or 2, wherein the ignition loss value of the glass cloth is 0.01 to 0.5 mass%.

10. A glass cloth according to claim 1 or 2, which is a constituent material for a printed circuit board.

11. A prepreg that comprises a glass cloth according to claim 1 or 2, and a thermosetting resin.

12. A printed circuit board that comprises a prepreg according to claim 11.

13. An integrated circuit that comprises a printed circuit board according to claim 12.

14. An electronic device that comprises a printed circuit board according to claim 12.

15. A method for producing a glass cloth, comprising:
a weaving step in which glass yarn is woven to obtain a glass cloth, and
a surface treatment step in which the glass yarn is subjected to deoiling treatment, and the glass yarn is then surface-treated with a surface treatment solution,
wherein the dielectric loss tangent of the glass cloth at 10 GHz after surface treatment is lower than the dielectric loss tangent of the glass cloth at 10 GHz before surface treatment.

16. The method for producing a glass cloth according to claim 15, wherein the surface treatment solution is prepared by adding an acidic aqueous solution to a silane coupling agent as a surface treatment agent.

17. The method for producing a glass cloth according to claim 15 or 16, wherein the surface treatment step comprises:
a step of controlling the temperature and pH of the surface treatment solution, and
a step of filtering the surface treatment solution.

18. The method for producing a glass cloth according to claim 15 or 16, which further comprises a step of opening the glass yarn after the surface treatment step.

19. The method for producing a glass cloth according to claim 15 or 16, which further comprises a step of examining white spots in the glass cloth after the surface treatment step.
